# EUROPEAN PATENT APPLICATION

(11) **EP 1 296 381 A1**
(43) Date of publication of application: **26.03.2003**
(21) Application number: 01402448.3
(22) Date of filing: 25.09.2001
(51) Int. Cl.: H01L 31/02, H01L 31/115, G01R 31/26

(54) **A pixel detector comprising radiation sensitive pixel elements**

(71) Applicant: Spinelix Limited, London NW11 7TJ (GB)
(72) Inventor: Caria, Mario, II 00191 Roma (IT)
(74) Representative: Texier, Christian

(57) **Abstract**

The detector comprises radiation sensitive pixel elements (20) and means for submitting all the pixel elements to a common electrical field.

The pixel elements are arranged in predetermined groups (Li) and the detector comprises means (36) for preventing any chosen group among the groups from being submitted to the common electrical field when the other groups are submitted to the common electrical field.

## Description

The invention concerns the fields of semiconductor radiation sensors. The invention relates to devices known in the art as hybrid pixel sensors or detectors.

Such devices usually are made of semiconductor wafers, most frequently high resistivity silicon, in which are implanted by ion reactor processing or thin film deposit tiny (micrometers) structures acting as single element detectors. When radiation impinges into such detectors, electron-hole pairs are generated and, if adequate electric field is applied to the structure, they drift and are collected to the pixels. The corresponding electrical current induced by the charge movement is transferred to an external electronic microchip circuit. Such a system is called in the art "hybrid pixel detector".

Ideally the electronic chip circuitry, physically separated in this system from the sensor, would better be integrated. New devices foresee integration although with a relatively simplified processing. In this case, the configuration is no longer called "hybrid" but "fully integrated" or "active pixel detector" or variations of them. In several applications where the processing and integration at very tiny dimensions (orders of tens of microns) are crucial elements (e.g. novel medical imaging applications), there are no alternative ways if not to "hybridize" the systems. This approach provides a better control of the steps of fabrication and uncouples the risks of failure from the sensor and the electronic circuits that can be ascribed for both either to fabrication defects in the chemical or mechanical treatments or to wrong engineering. The latter is done usually via very extensive and complex simulation that cannot cover for the risk of failures. This technology has therefore high risks and consequently high costs. The hybridized solution has high costs in the long term if a fully integrated system could be made available for the same application but has lower costs in the short term, as it allows a better control of the fabrication steps and corrections along the lines.

The hybridization happens via the electrical connection that must be done with best metallic alloys under specific circumstances to respect the compounds in the electronic chip and in the sensor. This processing step, in the art called "bonding" or "bump bonding, is often performed by using tiny (micrometers diameter) metallic deposits on one or both faces of the chip and the sensor, then thermally and mechanically processing them to transform them into tiny balls sticking to both the chip and the sensor pixels. This step is called "reflow" processing.

The process as such is very difficult and lots of skills and expensive equipments must be used in order to successfully bond with low failure rate (less than 1%). Such kind of processing is performed in few specialized laboratory in the world and usually commercially not available. Most of the companies performing it are using it for internal processing and not under customer demand.

Failures can sometimes be very high. It is not uncommon that companies performing the outside services perform many tests with failures up to 50% or more before delivering low number of failed pixels detectors. This is due to the fact that the processing is very specific for each type of sensor and chip. Changing the dimensions of the pixels, the metal alloys composition of them etc.. drastically changes the parameters for the bonding process.

The quantification of this failure is however puzzling. In facts, given the inherent inaccessibility of the pixel sensors once they are bonded, the only way to verify the success of each fully functioning electrical connection is to mount the system in a specific electronic board and make electrical tests. Given the possibility of failure of the electrical chip circuitry, as explained earlier, that can be ascribed either to wrong engineering or wrong processing, the real cause, in case of detection of failures, can be ascribed to the bonding hardly with certainty. On the other hand, it is impossible to probe each single pixel either of the sensor or of the chip before the assembly as this probing would damage them and would therefore compromise the bonding.

Even if detection of failure could be associated with a certain degree of trust to the bonding, the processing is completed so that all the system must be discarded with evident costs ineffectiveness.

An object of the invention is to enable detection, and preferably curing, of a failure (such as a bonding failure) in an hybrid pixel detector.

In this view, instant invention provides a pixel detector comprising radiation sensitive pixel elements and means for submitting all the pixel elements to a common electrical field, the pixel elements being arranged in predetermined groups, the detector comprising means for preventing any chosen group among the groups from being submitted to the common electrical field when the other groups are submitted to the common electrical field.

More generally, instant invention provides a pixel device comprising pixel elements and means for submitting all the pixel elements to a common electrical field, in which the pixel elements are arranged in predetermined groups and the device comprises means for preventing any chosen group among the groups from being submitted to the common electrical field when the other groups are submitted to the common electrical field.

The detector or the device of the invention may also present any of the following features :
- the pixel elements form an array on the detector;
- each group comprises at least one line of pixel elements;
- each group consists in one line of pixel elements;
- the preventing means comprises, for each group, a path of electrically conducting material arranged to be in electrical communication with the pixel elements of the group when the path and the group are submitted to a minimum predetermined voltage;
- the paths extend between the groups;
- each path is rectilinear;
- the pixel elements are elongated along a pixel direction, the paths being parallel to the pixel direction.
- each path comprises branches extending toward the respective pixel elements of the corresponding group;
- each pixel element of any of the groups comprises at least one branch extending toward the corresponding path;
- each path comprises an enlarged zone electrically directly accessible from a surface of the detector;
- the zone extends near an edge of the detector ; and
- at least one group of pixels among the groups is inactivated so as to prevent it from being submitted to the common electrical field when the other groups are submitted thereto.

The invention also concerns a detection system comprising a pixel detector according to the invention and an electronic circuit electrically connected to the detector.

The invention also concerns a device comprising at least a first and second pixel detectors according to the invention, in which the detectors are superimposed and lay in parallel planes, the groups comprising lines of pixel elements, the lines of the groups of the first detector extending in a direction non parallel to the direction of the lines of the groups of the second detector.

The invention further concerns a method for testing a pixel detector comprising radiation sensitive pixel elements, the method comprising the steps of :
- submitting to an electrical field only a predetermined group of pixels among the pixels of the detector; and
- detecting a voltage or an electrical current in the pixels of the group.

The method of the invention may also comprise any of the following features:
- it comprises the step of comparing a value obtained during the detection step with a predetermined value ;
- the predetermined value is a threshold used for all the groups;
- the predetermined value is a value obtained in an anterior test of the same group of the same detector;
- the pixel elements being arranged in groups, the submission and detection steps are executed for all the groups; and
- the detector comprising means for submitting all the pixel elements to a common electrical field, the method comprises, if the group comprises a pixel element having a defect, the step of connecting only the said group to a part of the detector arranged so that, when the electrical field is applied, the pixel elements of the group will not be submitted to the common electrical field.

The invention also provides a method for curing a defect in a pixel detector comprising radiation sensitive pixel elements and means for submitting all the pixel elements to a common electrical field, a given group of pixel elements comprising a pixel element having a defect being identified among the groups, the method comprising the step of connecting only the given group to a part of the detector arranged so that, when the common electrical field is applied, the pixel elements of the group will not be submitted to the common electrical field.

Other features and advantages of the invention will appear in the following description of two preferred embodiments given by way of examples only. On the drawings:
- Figure 1 is an exploded perspective view of an electrophoresis system comprising a detector according to the invention ;
- Figure 2 is a view of the under side of the detector of figure 1 ;
- Figure 3 is a section view along line III-III of the detector of figure 2 ; and
- Figure 4 is a perspective view of another system comprising two detectors according to the invention.

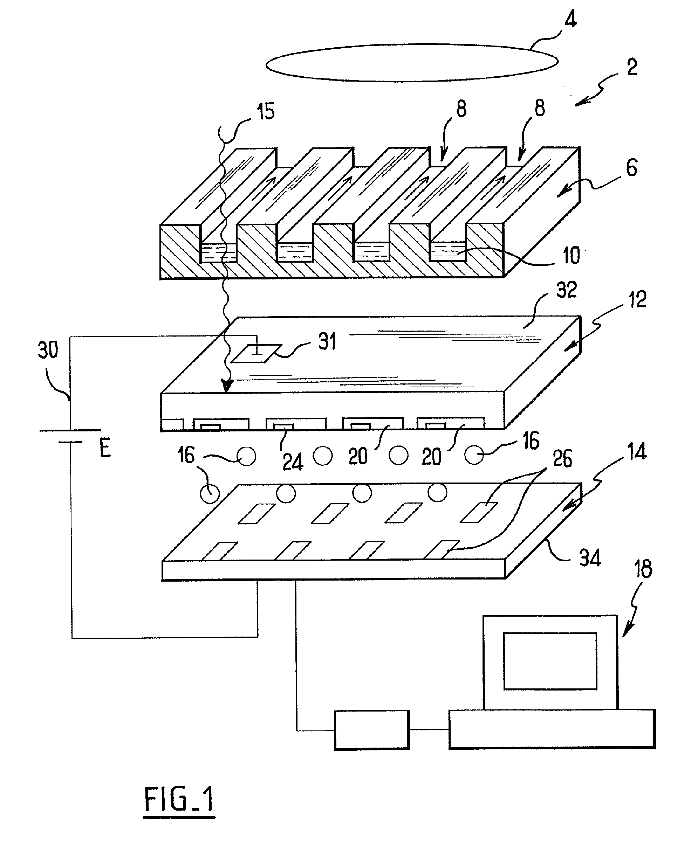

With reference to figure 1, the electrophoresis detection system 2 comprises a source 4 of radiation, for example UV or visible light. Underneath this source extends a lab-on-chip type device 6, for example comprising tiny parallel channels 8 receiving respective flows of fluids 10. Each fluid comprises biomolecules to be analyzed (DNA fragment, RNA, etc.). The channels are defined in a UV transparent substrate made in a material such as quartz. Underneath the substrate is the detector 12 of instant invention. Its shape is essentially flat and planar with a rectangular general form. Underneath detector 12 lays a flat electronic circuit 14 of a known type. Detector 12 and circuit 14 are interconnected by elements initially in the form of balls 16.

The source, the substrate, the detector and the circuit are superimposed and lay in parallel planes. Accordingly, a ray of light 15 emitted from source 4 passes through one channel 8, the fluid 10, the substrate and arrives on detector 12. The system also comprises analyzing and treatment means 18 including for example a personal computer arranged to receive signals from the electronic circuit 14.

We will now describe detector 12. This detector is made of semiconductor materials and comprises an array of pixels 20 forming lines Li (i being an integer) and columns Ci. The pixels extend on the under face 22 of detector 12 facing electronic circuit 14. Each pixel 20 comprises an aluminum contacting pad 24 aimed to be in electrical contact with one of the elements16, the latter being in contact with one cell 26 of the array of cells of circuit 14.

The system comprises means 30, including contacting pads 31 on the detector and the circuit, for creating a common electrical field E for example between the upper side 32 of detector 12 and the underside 34 of circuit 14, generating an electrical voltage therebetween applied to each couple pixel-detector.

As known in the art, detector 14 is such that when ray 15 impinges one pixel 20, he may, according to the molecules present in the corresponding fluid, generate electron-hole pairs in the semiconductor detector, generating an electrical current in the corresponding pixel 20 and cell 26 by virtue of field E. Accordingly, a corresponding signal is sent to computer 18 for treatment.

The pixel elements 20 constitute radiation sensitive elements. The pixel elements 20 are arranged in predetermined groups. In instant case, each group consists of one line Li of pixel elements. The detector comprises means adapted, if need be, for preventing any chosen group Li among the groups from being submitted to the common electrical field E when the other groups are submitted thereto. The preventing means comprises, for each group, a path 36 of electrically conducting material. The paths 36 extend between the groups Li and are rectilinear. Here, the pixel elements 20 have a rectangular form elongated along a common pixel direction 38, the aluminum pad 24 extending at an end thereof. The paths 36 are parallel to the pixel direction 38. Each line is associated with a respective path. In front of the pixels 20 of each line Li, the corresponding path 20 comprises branches 40 extending toward the respective pixel elements 20 of the line toward a center thereof but not contacting it. Moreover, each pixel element 20 of each group Li comprises at least one branch 42 extending toward the corresponding path 36 but not contacting it. In instant case, each pixel 20 comprises two branches extending toward the associated path, these branches being separated by the branch 40 of the path.

Besides, each path 36 comprises an enlarged zone 44 electrically directly accessible from a surface of the detector. All the zones 44 are situated near an edge 46 of the detector and form a column parallel thereto.

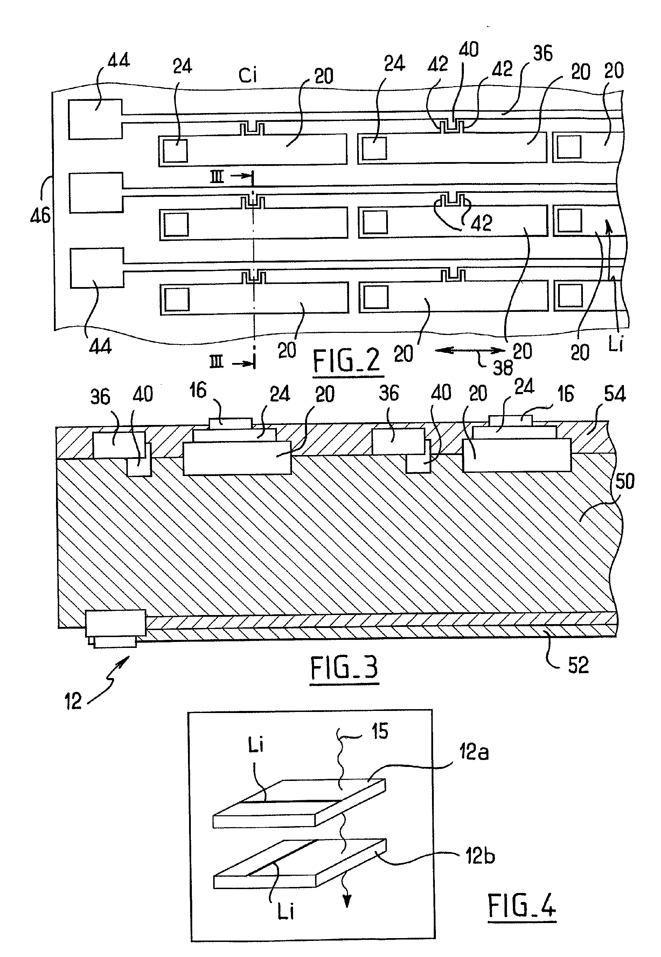

As shown on figure 3, the detector 12 comprises a main center layer 50 of silicon enriched with n implant generated by ionic bombing with phosphor atoms. The detector comprises protective upper 52 and lower 54 external layers of SiO2. (The section of the detector is illustrated upside down on figure 3.)

Each pixel 20 (together with its branches 42) and each branch 40 extend partially in the center layer 50 and in the lower layer 54. They both are made of silicon enriched with p implant, generated by ionic bombing with boron atoms.

The silicon is of high resistivity. The crystal is common to the p and n implants. The detector works according to the reverse-bias principle, known per se, corresponding to an electrical polarization reversed with respect to the natural signs of the diode electrodes.

The paths 36 or probe lines with zones 44 are made of aluminum connected to the branches 40.

The balls 16 finally constitute pads 16 contacting aluminum pads 24 of the pixels and accessible from the lower face 54 of the detector for contact with circuit 14.

Each path 36 is arranged to be in electrical communication with the pixel elements of the associated group Li when the path and the group are submitted to a minimum predetermined voltage of a few 0.01 microvolt. This minimum voltage depends on many factors, especially the distance between the associated branches 40 and 42. The man skilled in the art will have no difficulty for determining the minimum voltage corresponding to a given distance and vice-versa, for example by experimentation. This distance is here of 5 micrometer.

This system, once fabricated, may be tested according to the method of the invention. This method for testing the pixel detector is performed here when the common electrical field E is applied to all the pixels of the detector. The method comprises the step of submitting to a test electrical field T only a predetermined line Li of pixels among the pixels of the detector. This is accomplished by contacting the corresponding zone 44 with one electrode of the test device and the lower side of the circuit 14 with the other electrode of this device. The magnitude of the T field is for example of 4 V and is enough to create an electrical communication between path 36 and the pixels 20 of the line Li under test via layer 50. Accordingly, the test field T is applied to all the pixels of this line and not to the other lines.

The following steps consists in detecting a voltage or an electrical current in the pixels of the group and comparing a value obtained during the detection step with a predetermined value. The predetermined value may be a common threshold used for all the groups or a value obtained in an anterior test of the same group of the same detector. The T field is used only for test.

The steps are executed for all the groups. A current detected between the electrodes for a given group indicates that at least some of the pixels of the line Li under test are in electrical contact with circuit 14. But if the current or the voltage has a value different from the reference value, this may indicate that at least one pixel is not in contact with circuit 14. A voltage across the crystal between the single pixel and the probe line can be detected. Alternatively a current or a resistance. At full depletion, this gives the measure of the degree of isolation (vice-versa of electrical contact) between the probe line and the pixel line.

According to the invention, having detected a defect, the detector may then be cured. The curing method comprises, if the group Li comprises a pixel element 20 having a defect, the step of connecting only the said group Li, via the corresponding path 36, to a part of the system, such as the lower face of circuit 14. Accordingly, when the common electrical field is applied, the pixel elements of the group Li will remain at the potential of the lower face of the circuit and will not be submitted to the common electrical field E. Thus, the line is inactivated. The line Li may also be connected to the ground or to a given potential.

The result is a detector 12 in which at least one group Li of pixels 20 among the groups is inactivated so as to prevent it from being submitted to the common electrical field when the other groups are submitted thereto. This line will not give any signal when the system is used. Due to the fact that such a detector usually comprises dozens or hundreds of lines and columns, the inactivation of one line will not be a real handicap.

Figure 4 shows another embodiment of system 2 in which two detectors 12a, 12b are used in superimposed configuration, the detectors being parallel to each others, each ray 15 passing through both detectors. It is advantageous in this case to arrange the detectors so that the lines Li of the first detector 12a are parallel to the columns of the second detector 12b. In this case, even if one or a few lines are inactivated in each detector, no substantial loss of information will occur.

Accordingly, instant invention provides a method to detect and cure a bonding failure in a row (or column) of a hybrid pixel detector, by allowing the probing of an entire single line with simple, standard analytical probes of common use in semiconductor processing industry and research without any soldering. The invention allows, once the bonding has been completed, to verify the electrical connection of an entire line of pixels irrespective of its length and of the dimensions of the single pixel element.

The paths 36 run all along the pixel rows Li (or columns) in the inter-pixels space. The line has on at least one termination thereof a contact pad that can be easily accessed from an outside probe needle to sense the electrical field. Failure can be represented by detection of the variation of the electrical field with respect to the other probe lines and/or to the previous tests prior to bonding.

The invention could be used in a high resistivity "n" type silicon detector with "p+" type implantation probe lines running all along the "p+" pixels. The invention is more general and adequate structure can be built according to the semiconductor materials (e.g. GaAs CdTe or In and Zn compounds) that deserve different treatments of the line materials and processing. "n" type Silicon are however most common and mostly successfully used in hybrid pixel systems.

Even if one now proceeds to electrical tests via the electronics in the event of a failure, a typical high noise of the not responding pixel can be detected. Sometimes the pixels adjacent to a not bonded one give rise to high voltage signals, obscuring the radiation detection. By using the termination pads 44, a single pixel line Li can be isolated and the contribution of the noisy pixels isolated. One can then decide to keep the detector as efficient and just disconnect from the adjacent ones the pixels that are responsible for creating the noise. In this case, it is possible to connect to ground (e.g.) the pixel line containing the unconnected pixel(s) just via the probe line and the electrical stability is reset. This connection can be kept in the final system and can therefore save the assembled system with a minor loss on the sensitive pixels. For certain applications, the loss of an entire line of pixels for detection can be minor, for example if, in the design, the redundancy of detection along the direction orthogonal to the probe lines of the invention is high enough as in the case of figure 4.

A similar system can be built into the chip electronic wafer 14 rather than into the sensor wafer. The advantage of embedding the probe lines into the sensor wafer is essentially cost effectiveness.

The detection of radiation with high spatial resolution is a very vast field. Up to few years ago, the field was only covered by CCD (Charge Coupled Device) sensors. In recent years, the CMOS based detectors have been developed. They are being commercialized in several fields, in particular in commercial optics (camera etc..) for visible light. Most of the devices use non hybrid pixel detectors. As the current state of the art, these devices give the best performance versus cost. They are indicated above as "active pixel sensors" or "monolithic pixel sensors". The invention relates to hybrid pixel sensors used in radiation detection for which the application allows and justifies custom made and decoupled specific circuitry and sensors. Currently the most relevant applications valuable for commerce and research cover the fields of : particle detectors in nuclear physics research; imaging of UV, X and Gamma rays detectors in astronomy, medicine, biology, and material analysis with civil and military applications.

For example, the CERN (European Center for Nuclear Research) is massively equipped with hundreds of hybrid pixel detector systems using millions of pixels. They use custom made VLSI designed ASIC (Application Specific Integrated Circuit) and they are bump-bonded to specifically designed semiconductor sensors (almost all of Silicon) adequate for the spatial resolution needed to detect the position of fast and tiny particles. The massive and fast fabrication will take advantage of the present invention in view of the current or future detector systems in which the pixel sensors are more and more numerous. The present invention allows to reduce the cost of assembly and fabrication and to cure the faulty ones.

As another example, digital radiology in the field of X rays will be based in the future on hybrid pixel detectors with semiconductor sensors (e.g GaAs or CdZnTe alloys). The ASIC, the materials and the sensors are such that only hybrid sensors allow the performances wanted in terms of spatial resolution and radiation dose, making the device appealing for the application.

The detector shown in figure 1 has been developed for the application of imaging of biomolecules. This is done by UV irradiation of the Silicon sensor, capable of collecting the light from the back of the sensor, opposite to the side in which the implantation of the probe lines are. The ASIC is bump bonded to the same side. Such kind of sensor can be used to image DNA or Protein compounds with high efficiency with or without markers attached to the compound.

The detector is placed underneath the radiation source, both sandwiching the biological support. Alternatively it can be placed aside at an adequate angle with respect to UV laser light. These configurations are not directly connected to the present invention but are just mentioned here for the sake of explaining the application.

The method is used for identifying faulty elements in an hybrid pixel detector made out of a semiconductor (not exclusively) pixel sensor and a semiconductor (not exclusively) electronic integrated chip circuit.

The system consists of an electrical connection running along a pixel line to probe and isolate the faulty connections between the sensor wafer and the chip wafer.

The method consists on adequately connecting the probe line to help isolate and test the faulty pixel element.

## Claims

1. A pixel detector comprising radiation sensitive pixel elements (20) and means (31) for submitting all the pixel elements to a common electrical field (E), **characterized in that** the pixel elements are arranged in predetermined groups (Li) and the detector comprises means (36) for preventing any chosen group among the groups from being submitted to the common electrical field when the other groups are submitted to the common electrical field.

2. A detector according to claim 1, **characterized in that** the pixel elements (20) form an array on the detector.

3. A detector according to any of claims 1 or 2, **characterized in that** each group comprises at least one line (Li) of pixel elements (20).

4. A detector according to any of claims 1 to 3, **characterized in that** each group consists in one line (Li) of pixel elements.

5. A detector according to any of claims 1 to 4, **characterized in that** the preventing means comprises, for each group (Li), a path (36) of electrically conducting material arranged to be in electrical communication with the pixel elements (20) of the group when the path and the group are submitted to a minimum predetermined voltage.

6. A detector according to claim 5, **characterized in that** the paths (36) extend between the groups (Li).

7. A detector according to any of claims 5 or 6, **characterized in that** each path (36) is rectilinear.

8. A detector according to any of claims 5 to 7, **characterized in that** the pixel elements (20) are elongated along a pixel direction (38), the paths (36) being parallel to the pixel direction.

9. A detector according to any of claims 5 to 8, **characterized in that** each path (36) comprises branches (40) extending toward the respective pixel elements (20) of the corresponding group (Li).

10. A detector according to any of claims 5 to 9, **characterized in that** each pixel element (20) of any of the groups comprises at least one branch (42) extending toward the corresponding path (36).

11. A detector according to any of claims 5 to 10, **characterized in that** each path (36) comprises an enlarged zone (44) directly accessible from a surface of the detector.

12. A detector according to claim 11, **characterized in that** the zone (44) extends near an edge of the detector.

13. A detector according to any of claims 1 to 12, **characterized in that** at least one group (Li) of pixel elements (20) among the groups is inactivated so as to prevent it from being submitted to the common electrical field (E) when the other groups are submitted thereto.

14. A detection system (2) comprising a pixel detector (12) and an electronic circuit (14) electrically connected to the detector, **characterized in that** the pixel detector is according to any of claims 1 to 13.

15. A device comprising at least a first and second pixel detectors (12a, 12b) according to claim 13, **characterized in that** the detectors are superimposed and lay in parallel planes, the groups comprising lines of pixel elements, the lines of the groups of the first detector extending in a direction non parallel to the direction of the lines of the groups of the second detector.

16. A method for testing a pixel detector (12) comprising radiation sensitive pixel elements (20), the method comprising the steps of :
- submitting to an electrical field only a predetermined group (Li) of pixels among the pixels of the detector; and
- detecting a voltage or an electrical current in the pixels of the group.

17. A method according to claim 16, **characterized in that** it comprises the step of comparing a value obtained during the detection step with a predetermined value.

18. A method according to claim 17, **characterized in that** the predetermined value is a threshold used for all the groups.

19. A method according to any of claims 17 or 18, **characterized in that** the predetermined value is a value obtained in an anterior test of the same group of the same detector.

20. A method according to any of claims 17 to 19, **characterized in that**, the pixel elements being arranged in groups, the submission and detection steps are executed for all the groups.

21. A method according to any of claims 17 to 20, **characterized in that**, the detector comprising means (30, 31) for submitting all the pixel elements (20) to a common electrical field, the method comprises, if the group comprises a pixel element having a defect, the step of connecting only the said group to a part of the detector arranged so that the pixel elements of the group will not be submitted to the common electrical field (E) when the electrical field is applied.

22. Method for curing a defect in a pixel detector comprising radiation sensitive pixel elements (20) and means (30, 31) for submitting all the pixel elements to a common electrical field (E), a given group (Li) of pixel elements comprising a pixel element having a defect being identified among the groups, the method comprising the step of connecting only the given group to a part of the detector arranged so that the pixel elements of the group will not be submitted to the common electrical field when the common electrical field is applied.

23. A pixel device comprising pixel elements (20) and means (31) for submitting all the pixel elements to a common electrical field (E), **characterized in that** the pixel elements are arranged in predetermined groups (Li) and the device comprises means (36) for preventing any chosen group among the groups from being submitted to the common electrical field when the other groups are submitted to the common electrical field.
